(19) Europäisches Patentamt
European Patent Office
Office européen des brevets

(11) **EP 1 811 545 B1**

(12) **EUROPEAN PATENT SPECIFICATION**

(45) Date of publication and mention
of the grant of the patent:
**11.01.2017 Bulletin 2017/02**

(21) Application number: **05800365.8**

(22) Date of filing: **07.11.2005**

(51) Int Cl.:
*G03F 7/20* (2006.01)    *H05G 2/00* (2006.01)
*B82Y 10/00* (2011.01)

(86) International application number:
**PCT/JP2005/020356**

(87) International publication number:
**WO 2006/049274 (11.05.2006 Gazette 2006/19)**

(54) **EXPOSURE EQUIPMENT AND EXPOSURE METHOD**

BELICHTUNGSGERÄT UND BELICHTUNGSVERFAHREN

ÉQUIPEMENT D'EXPOSITION ET PROCÉDÉ D'EXPOSITION

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **08.11.2004   JP 2004323247**

(43) Date of publication of application:
**25.07.2007   Bulletin 2007/30**

(73) Proprietor: **Nikon Corporation
Tokyo 108-6290 (JP)**

(72) Inventors:
• **KONDO, Hiroyuki
NIKON CORPORATION
Chiyoda-ku, Tokyo 1008331 (JP)**

• **MIYACHI, Takashi,
NIKON CORPORATION
Chiyoda-ku, Tokyo 1008331 (JP)**

(74) Representative: **Viering, Jentschura & Partner
mbB
Patent- und Rechtsanwälte
Grillparzerstraße 14
81675 München (DE)**

(56) References cited:
**EP-A2- 1 333 328        WO-A2-2004/017380
JP-A- 2000 036 456      JP-A- 2000 091 195
JP-A- 2003 224 052      JP-A- 2003 224 053
JP-A- 2004 006 716      JP-A- 2004 039 927
US-A- 5 883 701          US-A1- 2003 037 878
US-A1- 2003 098 959**

## Description

### Technical Field

The present invention relates to an exposure equipment and, more particularly, to an exposure equipment that generates pulsed light by producing plasma from a target material to carry out exposure with the pulsed light.

### Background Art

Conventionally, in an exposure equipment using pulsed light, a light emission instruction (trigger) is given from the exposure equipment side to a light source and the light source emits exposure light in response to this. In other words, the exposure equipment side performs an exposure operation by triggering the light source so that the timing is coincident with stage drive of the equipment. Due to this, it is possible to obtain a uniform quantity of exposure light within the exposure field.

On the other hand, one kind of EUV light source uses X-rays (EUV light) radiated from plasma produced from a target material that is supplied intermittently. As this type of light source, there is, for example, a droplet laser produced plasma X-ray source, which produces plasma by irradiating a droplet that drops from the tip of a nozzle with laser light, see for example Japanese Unexamined Patent Application Publication No. 2000-215998.

Document US 2003/037878 A1 shows an exposure apparatus having an illumination unit, a mask stage, a wafer stage and a control unit, wherein the movements of the mask stage and the wafer stage are synchronized and controlled. Document US 5883701 A shows a scanning projection exposure apparatus having an illumination optical system, a projection optical system, a moving device, a position measuring device and a controller, wherein the controller determines whether the positional relation is in a predetermined range. Document JP 2004-039927 A shows a device for generating optical wave.

### Disclosure of the Invention

However, in such a light source, the moment when EUV light is emitted depends on the supply timing of a target material, unrelated to the timing inside the exposure equipment. Because of this, even if the exposure equipment side triggers the light source, the EUV light is not emitted with the timing desired by the exposure equipment. The maximum lag (delay) in the timing is the inverse of the repetition frequency of the light source. For example, when the repetition frequency is 1 kHz, the maximum delay will be 1 ms.

Because of this, at the worst, the number of pulses irradiated at the scan starting portion and the scan ending portion within the exposure field is short by one pulse due to the lag between the start of the movement of the exposure equipment stage and the light emission moment of the EUV light, and the uniformity in the quantity of exposure light within the field is degraded.

The present invention has been developed in order to solve the conventional problem and aims at providing an exposure equipment capable of obtaining a high degree of uniformity in the quantity of exposure light even when pulsed light generated by producing plasma from a target material is used for a light source of exposure.

The present invention provides an exposure equipment according to claim 1. Further advantageous embodiments are set out in the dependent claims.

(Effects of the Invention)

In the exposure equipment of the present invention, the photosensitive substrate stage is controlled so that, before exposure onto the photosensitive substrate is started, the exposure starting point or the exposure ending point and the light emission timing coincide with each other based on the drive timing of the photosensitive substrate stage and the light emission timing of the pulsed light, and therefore, it is possible to obtain a high degree of uniformity in the quantity of exposure light also when pulsed light generated by producing plasma from a target material is used for the light source of exposure.

In the exposure equipment of the present invention, the photosensitive substrate stage is controlled so that, before exposure onto the photosensitive substrate is started, the exposure starting point or the exposure ending point and the light emission timing of the pulsed light coincide with each other based on the drive conditions of the photosensitive substrate stage and the light emission conditions of the pulsed light, and therefore, it is possible to obtain a high degree of uniformity in the quantity of exposure light also when pulsed light generated by producing plasma from a target material is used for the light source of exposure.

### BRIEF DESCRIPTION OF THE DRAWINGS

Fig. 1 is an explanatory diagram showing a first embodiment of an exposure equipment of the present invention.

Fig. 2 is an explanatory diagram showing a time chart of the wafer stage control of a control apparatus in Fig. 1.

Fig. 3 is an explanatory diagram showing a time chart of the wafer stage control in an example of the exposure equipment which does not form part of the present invention.

Fig. 4 is an explanatory diagram showing a second embodiment of the exposure equipment of the present invention.

### *Best Modes for Carrying Out the Invention*

Embodiments of the present invention will be described below in detail using drawings.

(First embodiment)

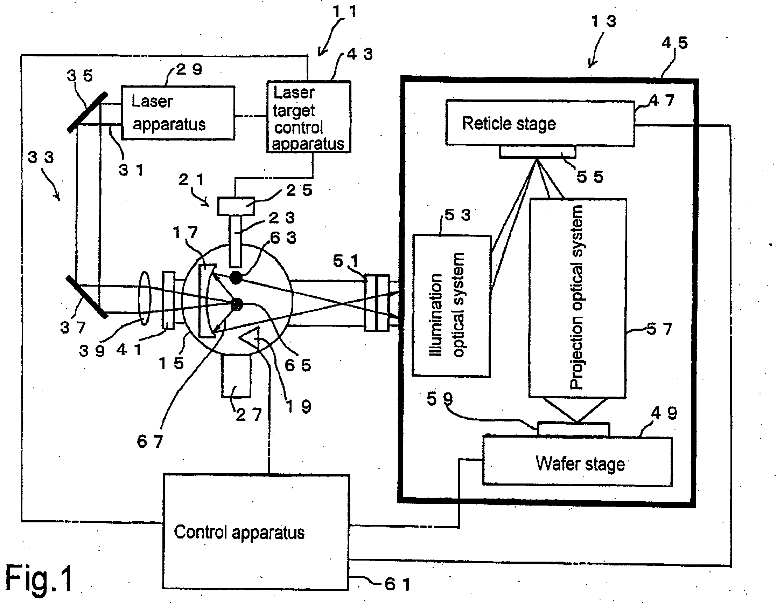

Fig. 1 shows a first embodiment of an exposure equipment of the present invention. In the present embodiment, a laser produced plasma X-ray source using a droplet target is used for a light source of exposure.

The exposure equipment of the present embodiment has an EUV light generation part 11 and an exposure part 13.

The EUV light generation part 11 generates pulsed light composed of EUV light by producing plasma from a target material. The EUV light generation part 11 has a vacuum chamber 15. Within the vacuum chamber 15, a condensing mirror 17 that reflects the EUV I ight and an EUV light detector 19 that detects the EUV light are arranged.

Above the vacuum chamber 15, a target material supply apparatus 21 that supplies a target material is arranged. The target material supply apparatus 21 has a nozzle 23 that opens into the vacuum chamber 15 and a supply part 25 that supplies the target material to the nozzle 23. Below the vacuum chamber 15, a collecting mechanism 27 that collects the target material is arranged.

On the lateral side of the vacuum chamber 15, a laser light optical system 33 that introduces laser light 31 from a laser apparatus 29 that generates laser light into the vacuum chamber 15 is arranged. The laser light 31 from the laser apparatus 29 is condensed by a lens 39 after reflected by reflecting mirrors 35 and 37 and introduced into the vacuum chamber 15 via a laser introduction window 41 formed in the vacuum chamber 15.

The laser apparatus 29 and the supply part 25 of the target material supply apparatus 21 are controlled by a laser target material control apparatus 43.

The exposure part 13 has a vacuum chamber 45. Within the vacuum chamber 45, a reticle stage 47 and a wafer stage 49 are arranged. The EUV light generated in the EUV light generation part 11 is introduced from an EUV light introduction part 51 into an illumination optical system 53 within the vacuum chamber 45 and introduced to the undersurface of a reticle 55 arranged beneath the reticle stage 47 by the illumination optical system 53. The EUV light patterned and reflected by the reticle 55 is used for irradiation and exposure of a wafer 59, which is a photosensitive substrate placed on the top surface of the wafer stage 49, via a projection optical system 57. In the present embodiment, scan exposure is performed by driving the reticle stage 47 and the wafer stage 49.

In Fig. 1, reference numeral 61 denotes a control apparatus. The control apparatus 61 receives a signal from the EUV light detector 19 and the laser target material control apparatus 43. In addition, the control apparatus 61 receives a drive control signal from the reticle stage 47 and the wafer stage 49. Then, the control apparatus 61 controls the reticle stage 47, the wafer stage 49, and the laser target material control apparatus 43.

In the above-described exposure equipment, a droplet target 63 made of, for example, liquefied xenon is ejected intermittently from the tip of the nozzle 23 by means of the supply part 25 of the target material supply apparatus 21. When the ejected target 63 reaches a predetermined position (the focal point of the condensing mirror 1 7), the laser light 31 is emitted from the laser apparatus 29 and condensed onto the target 63 via the lens 39, producing plasma from the target material.

EUV light 67 emitted from plasma 65 is condensed by the condensing mirror 17 and introduced into the illumination optical system 53 of the exposure part 13. The EUV light 67 emitted from the illumination optical system 53 enters the reticle 55 of the reticle stage 47 and is reflected. The light reflected by the reticle 55 enters the projection optical system 57 and forms an image of a fine pattern on the reticle 55 onto the wafer 59 to which a resist has been applied.

Here, the timing of the laser apparatus 29 and the supply part 25 of the target material supply apparatus 21 is controlled by the laser target control apparatus 43 so that the target 63 is irradiated with the laser light 31 when the target 63 is situated at a predetermined position (the focal point of the condensing mirror 17). For example, the timing is controlled by adjusting the light emission timing of the laser light 31 traveling from the laser apparatus 29 toward the target 63. By the way, this adjustment is made possible by, for example, detecting the light emission state of the EUV light by a detector, such as the EUV light detector 19 etc. In addition, it is required to adjust in advance so that the pulse period of the laser light emitted from the laser apparatus 29 and the supply period of the target material (the same period as that with which the target 63 passes through the focal point of the condensing mirror 17) are the same as the designed periods.

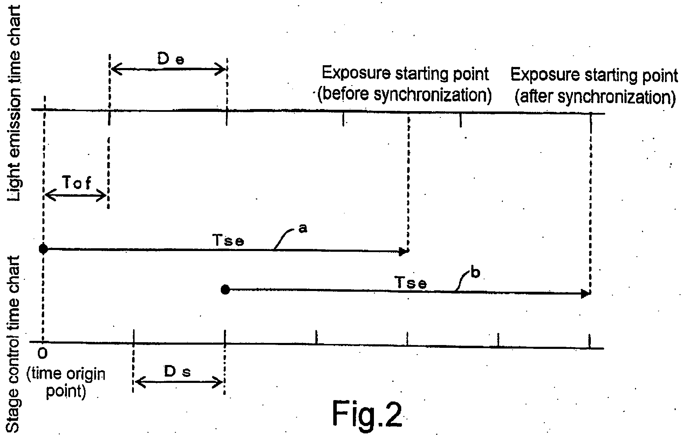

On the other hand, as shown in Fig. 2, the path tracking control of the wafer stage 49 is discrete and the period of the drive control is Ds. In addition, the light emission of the plasma 65 is also discrete and the light emission period of the EUV light (also referred to as pulsed light) is De and therefore both are not synchronized with each other.

Then, in one-shot scan exposure, time Tse from the moving start to the exposure start of the wafer stage 49 is known at the point of time when the path of the wafer stage 49 is generated. In addition, if the drive control timing immediately before the moving start is set to the time origin point 0, it is possible to measure a time difference Tof from the time origin point to the point of time when pulsed light is emitted immediately thereafter by a certain measurement portion of hardware type, and therefore, it can be regarded as known.

In the present embodiment, in order to find the time difference Tof, the plasma 65 is caused to emit light before the exposure start and a delay time between the light emission timing of pulsed light and the drive control timing of the wafer stage 49 is detected. The time difference Tof is found by monitoring the pulsed light by the EUV light detector 19. In the present embodiment, a photodiode is used as the EUV light detector 19. When pulsed light is generated, an electric current (voltage) is output from the photodiode and the light emission timing of the pulsed light is known by monitoring the signal. Tof can be known by investigating the time difference between the signal from the photodiode and the control period of the drive control timing of the wafer stage 49 accommodated within the exposure equipment.

Here, the light emission timing Tf (n) of the pulsed light is expressed by the following expression, where n is an integer.

$$Tf (n) = n \times De + Tof$$

In addition, where m is an integer, the drive control timing Ts (m) of the exposure start is expressed by the following expression.

$$Ts (m) = m \times Ds + Tse$$

As shown by a straight line a in Fig. 2, when the moving of the wafer stage 49 is started at the initial time origin point 0, the light emission timing of the pulsed light does not necessarily coincide with the timing with which the wafer stage 49 reaches the exposure starting point. In order to match both, moving start of the wafer stage 49 is caused to delay as shown by a straight line b in Fig. 2 (since the drive control is discrete, the delay will be generated for each sample Ds).

Here, the minimum n and m, which satisfy |Tf (n) - Ts (m)| < Δ (Δ is an allowable time difference), are searched for. By using this m, that is, by delaying the drive control timing of the moving start of the wafer stage 49 from the time origin point 0 by m samples, it is possible to control (for synchronization) so that the light emission starting point of the pulsed light comes near the exposure starting point.

By the way, depending on the values of the period De and the period Ds and the initial value of the timing, the values of n and m become too large and there is the possibility that it takes much time until a state in which exposure can be started is brought about. When this leads to a problem, it is also possible to maintain synchronization with small values of n and m by shifting in advance the light emission timing or the drive control timing of the wafer stage, that is, by shifting the phase.

As a means for shifting the phase, it is possible to employ a method of changing the starting position (initial position) of the path, a method of adjusting the parameter (acceleration) for generating the path, or the like.

In the above-described exposure equipment, the moving start timing of the wafer stage 49 is controlled so that the exposure starting point and the light emission timing coincide (synchronize) with each other, based on the drive control timing of the wafer stage 49 and the light emission timing of the pulsed light before exposure onto the wafer 59 is started, and therefore, it is possible to obtain a high degree of uniformity in the quantity of exposure light even when the pulsed light generated by producing plasma from the target material is used for the light source of exposure. The wording coincidence (synchronization) referred to here includes an allowance of a time difference to the degree that does not cause a problem of the specification of the equipment.

In other words, it is made possible to reduce the lag between the exposure starting time of the wafer stage 49 and the light emission time of the pulsed light and to always set the number of pulses in the exposure field of the pulsed light with which the scan starting portion in the exposure field is irradiated to a certain number of pulses, and what is essential is to make uniform the quantity of exposure light in the exposure field.

By the way, in the above-described exposure equipment, the light emission timing of the EUV light is detected using the EUV light detector 19, however, the light emission timing may be detected by other methods. For example, as described above, it is possible to adjust in advance so that the supply timing of the target 63 and the timing of the pulse of the pulsed laser light for plasma excitation emitted from the laser apparatus 29 are synchronized with each other. In such a case, it is possible to control the light emission timing of the laser light of the laser apparatus 29 as the light emission timing of the EUV light. When such a control is performed, if the laser light emission period of the laser apparatus 29 differs from the supply period of the target 63, it is preferable to take the difference into consideration.

(Example)

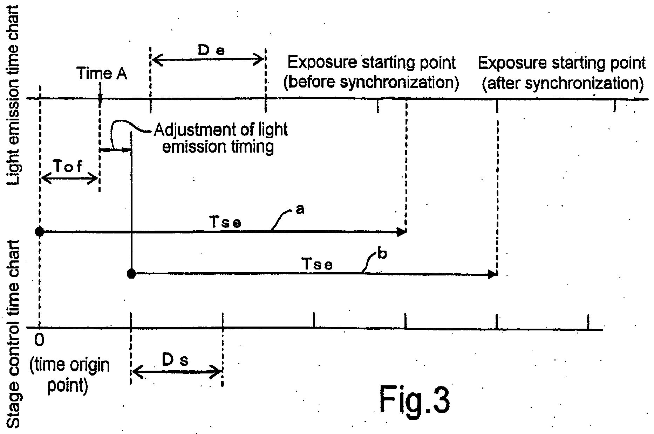

Fig. 3 shows a time chart in an example of an exposure equipment which does not form part of the present invention.

By the way, in the example, the same parts as those in the first embodiment are assigned the same symbols and its detailed explanation will be omitted.

In the example, before exposure onto the wafer 59 is started, the light emission timing is adjusted so that the exposure start and the light emission timing coincide with each other based on the drive control timing of the wafer stage 49 and the light emission timing of the pulsed light.

In the example, the adjustment of the light emission timing is made by changing the phase of the pulsed light. In other words, the control apparatus 61 detects an amount of lag Tof between the drive control timing of the wafer stage 49 and the light emission timing of the pulsed light at time A in Fig. 3 (the same as that in the first embodiment). Then, based on the result, it is calculated how much the light emission timing of the pulsed light should be shifted so as its timing to coincide with the drive control timing of the wafer stage 49 in the shortest time. Then, this calculation result is fed back to the laser target material control apparatus 43. Due to this, the ejection timing of the target 63 to be ejected from the nozzle 23 by means of the supply part 25 of the target material supply apparatus 21 is changed and the light emission timing (phase) of the pulsed light is shifted (in the figure, the timing from light emission at time A to the next light emission is adjusted). In the example, the light emission frequency (repetition frequency) of the pulsed light is not changed.

In the example, the same effect as that in the first embodiment can also be obtained, however it is possible to make the drive control timing of the wafer stage 49 and the light emission timing of the pulsed light coincide with each other in a shorter time compared to the first embodiment. Consequently, it is possible to improve the throughput of the exposure equipment by reducing the standby time.

By the way, an example is described, in which the light emission timing (phase) of the pulsed light is shifted, however, it may also be possible to change the light emission frequency (repetition frequency) of the pulsed light.

In other words, when the number of pulses of the pulsed light with which a point on the wafer 59 is irradiated is sufficiently large and the degree of uniformity in the quantity of exposure light is sufficiently high, it will not bring about any problem even if the light emission frequency of the pulsed light is changed more or less. Consequently, in such a case, it may also be possible to change the light emission frequency of the pulsed light so that the drive control timing of the wafer stage 49 and the light emission timing of the pulsed light coincide with each other. In addition, it is also possible to change the phase and frequency of the drive control timing of the stage.

(Second embodiment)

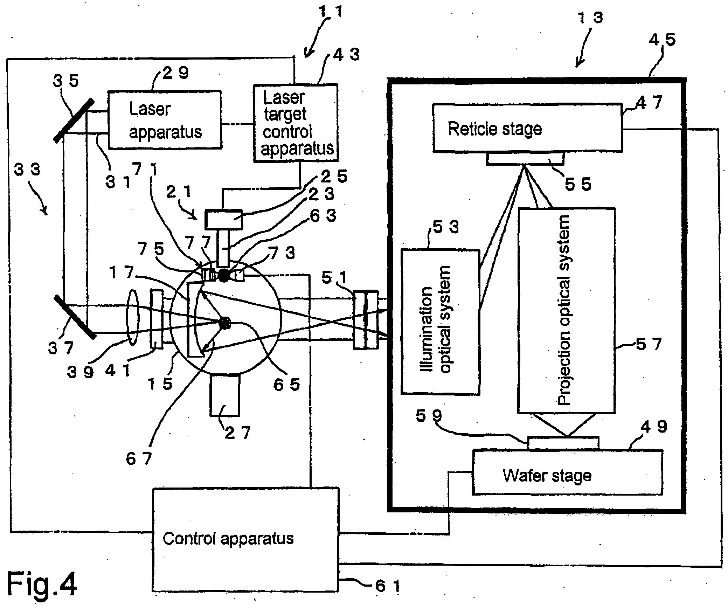

Fig. 4 shows a second embodiment of the exposure equipment of the present invention.

By the way, in the present embodiment, the same parts as those in the first embodiment are assigned the same symbols and its detailed explanation will be omitted.

In the present embodiment, the light emission timing of the pulsed light is monitored by monitoring the timing with which the target material is ejected from the nozzle 23.

In other words, in the present embodiment, on one side of the position through which the target 63 passes, a light irradiator 71 is arranged and a light detector 73 is arranged in opposition to the light irradiator 71. The light irradiator 71 has a light emitting diode 75 and a condensing lens 77. Design is made such that the light emitted from the light emitting diode 75 focuses on the position through which the target 63 passes by the condensing lens 77. At the time when the target 63 passes through, the light from the light emitting diode 75 is blocked or scattered by the target 63 and therefore the quantity of light detected by the light detector 73 decreases and the output signal from the light detector 73 is reduced in level.

Because of this, it is possible to monitor the time when the target 63 has passed through by monitoring the output signal from the light detector 73. Then, since the time from when the target 63 passes through until the target 63 emits light is fixed, it is possible to estimate the light emission timing of the pulsed light from the detection signal of the light detector 73.

In the present embodiment, it is also possible to obtain the same effect as that in the first embodiment.

In the present embodiment, an example is described, in which the time when the target 63 passes through is monitored by the light detector 73, however, it may also be possible to estimate the light emission timing of the pulsed light from a material supply signal to the target material supply apparatus 21 by finding the correlation between the material supply signal output to the supply part 25 of the target material supply apparatus 21 from the laser target material control apparatus 43 and the timing of the drop of the target material.

For example, when a pulse voltage is applied to the supply part 25 of the target material supply apparatus 21, a droplet falls from the nozzle 23 in a predetermined response time in accordance therewith. Because of this, it is possible to know the light emission time of the pulsed light by knowing only the timing of the application of the pulse voltage by measuring in advance the time difference between the time of the application of the pulse voltage and the light emission of the pulsed light.

(Supplementary items of the embodiments)

As described above, the present invention is described by the embodiments described above, however, the technical scope of the present invention is not limited to the embodiments described above and for example, the following embodiments may be possible.

(1) In the embodiments described above, an example is described, in which the exposure starting point and the light emission point of the pulsed light are synchronized with each other, however, it may also be possible to synchronize the exposure ending point with the light emission point of the pulsed light. Which restriction is more important is determined by the shape etc. of the shot to be subjected to exposure and when it is not possible to synchronize both, it is desirable to control so that only the more important one is synchronized. For example, which one should be given priority may be determined depending on the presence/absence of a pattern in the vicinity of the edge of the shot or the presence/absence of a pattern for which a higher degree of uniformity in the illumination is required.

(2) Also described is an example, in which the light emission timing of the pulsed light is monitored by the EUV light detector 19, however, it may also be possible to monitor using, for example, a light detector having the sensitivity to visible light and infrared regions. In other words, since ultraviolet light, visible light, infrared light, etc. are generated from the plasma 65 as well as the EUV light 67, it is possible to know the light emission timing of the EUV light 67 by monitoring them.

(3) In the embodiments described above, an example is described, in which the laser produced plasma light source is used for the light source of the EUV light 67, however, it may also be possible to use a discharge plasma X-ray source that generates the EUV light by discharging in accordance with the intermittent supply of the target material between electrodes. In addition, as an intermittent supply method of a target material, there is a . method of ejecting a gas intermittently between electrodes or a method of supplying a target material in a liquid state, or fine particle state between electrodes.

(4) In the embodiments described above, an example is described, in which liquefied xenon is used as a target material, however, it may also be possible to use tin (Sn). In this case, it is desirable to heat, for example, a polystyrene resin in which Sn solid fine particles are dispersed and use it in a liquefied state.

(5) In the embodiments described above, the control timing of the stage of the photosensitive substrate is synchronized with the light emission timing, however, it is also possible to synchronize the control timing of the reticle stage with the light emission timing in the same manner.

**Claims**

1. An exposure equipment used with a light emitting portion (11) that generates pulsed light having a light emitting period (De) by producing plasma from a target material (63) supplied intermittently from a supply portion (21), comprising:

   a reticle stage (47) on which a reticle (55) to be irradiated with said pulsed light is arranged and movable along a scanning direction during a scan exposure time;
   a photosensitive substrate stage (49) on which a photosensitive substrate (59) to be irradiated with the pulsed light is arranged and movable along the scanning direction at a drive control period (Ds) during the scan exposure time, the pulsed light being patterned by said reticle (55); and
   a control portion (61) adapted for obtaining information regarding a drive timing of said photosensitive substrate stage (49) and a light emission timing of said pulsed light before exposure onto said photosensitive substrate (59) is started, and for controlling a movement of said photosensitive substrate stage (49) so that a timing of said photosensitive substrate stage (49) reaching an exposure starting point or an exposure ending point and a timing of said pulsed light reaching said photosensitive substrate (59) coincide with each other based on the obtained information.

2. The exposure equipment according to claim 1, further comprising:

   a detection portion (73) for detecting the light emission timing before the exposure is started.

3. The exposure equipment according to claim 1, wherein
   in use said timing of said pulsed light reaching said photosensitive substrate (59) is defined based on a supply timing of said target material (63) from said supply portion (21).

4. The exposure equipment according to claim 3, wherein in use the supply timing of said target material (63) is defined by detecting a supply moment of said target material (63) from the supply portion (21).

5. The exposure equipment according to claim 3, wherein in use the supply timing of said target material is defined by a supply control signal of the supply portion (21).

6. The exposure equipment according to any one of claim 1 to claim 5,
   wherein in use the drive control period is a fixed period.

7. The exposure equipment according to claim 6, wherein in use said control portion (61) starts exposure by synchronizing said control period with a period of said pulsed light.

8. The exposure equipment according to claim 7, wherein in use said control portion (61) performs said synchronization by delaying a moving start time of said photosensitive substrate stage (49).

**9.** The exposure equipment according to claim 1, wherein in use the light emission timing is defined based on the supply timing of said target material (63) from the supply portion (21).

**10.** The exposure equipment according to claim 1, wherein in use the light emission timing is defined by detecting said pulsed light.

**Patentansprüche**

**1.** Eine Belichtungsausrüstung, die mit einem lichtemittierenden Abschnitt (11) verwendet wird, der gepulstes Licht erzeugt, das eine lichtemittierende Dauer (De) hat, durch Erzeugen eines Plasmas von einem Zielmaterial (63), das mit Unterbrechungen von einem Zuführabschnitt (21) zugeführt wird, aufweisend:

einen Maskenträger (47), an dem eine mit dem gepulsten Licht zu bestrahlende Maske (55) angeordnet ist und der während einer Scanbelichtungszeit entlang einer Scanrichtung bewegbar ist;
einen fotosensitives-Substrat-Träger (49), an dem ein mit dem gepulsten Licht zu bestrahlendes fotosensitives Substrat (59) angeordnet ist und der während der Scanbelichtungszeit entlang der Scanrichtung bei einer Antriebssteuerungsdauer (Ds) bewegbar ist, wobei das gepulste Licht durch die Maske (55) strukturiert ist; und
einen Steuerungsabschnitt (61), der angepasst ist zum Erhalten von Informationen bezüglich eines Antriebstimings des fotosensitives-Substrat-Trägers (49) und eines Lichtemissionstimings des gepulsten Lichts bevor eine Belichtung auf das fotosensitive Substrat (59) gestartet ist und zum Steuern einer Bewegung des fotosensitives-Substrat-Trägers (49) basierend auf den erhaltenen Informationen, so dass ein Timing des Erreichens eines Belichtungsstartpunktes oder eines Belichtungsendpunktes durch den fotosensitives-Substrat-Träger (49) und ein Timing des Erreichens des fotosensitiven Substrats (59) durch das gepulste Licht zusammenfallen.

**2.** Die Belichtungsausrüstung gemäß Anspruch 1, ferner aufweisend:

einen Ermittlungsabschnitt (73) zum Ermitteln des Lichtemissionstimings bevor die Belichtung gestartet ist.

**3.** Die Belichtungsausrüstung gemäß Anspruch 1, wobei

in Verwendung das Timing des Erreichens des fotosensitiven Substrats (59) durch das gepulste Licht basierend auf einem Zuführtiming des Zielmaterials (63) von dem Zuführabschnitt (21) definiert ist.

**4.** Die Belichtungsausrüstung gemäß Anspruch 3, wobei in Verwendung das Zuführtiming des Zielmaterials (63) durch Ermitteln eines Zuführmoments des Zielmaterials (63) von dem Zuführabschnitt (21) definiert ist.

**5.** Die Belichtungsausrüstung gemäß Anspruch 3, wobei in Verwendung das Zuführtiming des Zielmaterials durch ein Zuführsteuersignal des Zuführabschnitts (21) definiert ist.

**6.** Die Belichtungsausrüstung gemäß irgendeinem des Anspruchs 1 bis Anspruchs 5, wobei in Verwendung die Antriebssteuerungsdauer eine festgesetzte Dauer ist.

**7.** Die Belichtungsausrüstung gemäß Anspruch 6, wobei in Verwendung der Steuerungsabschnitt (61) die Belichtung durch Synchronisieren der Steuerungsdauer mit einer Dauer des gepulsten Lichts startet.

**8.** Die Belichtungsausrüstung gemäß Anspruch 7, wobei in Verwendung der Steuerungsabschnitt (61) die Synchronisierung durch Verzögern einer Bewegungsstartzeit des fotosensitives-Substrat-Trägers (49) ausführt.

**9.** Die Belichtungsausrüstung gemäß Anspruch 1, wobei in Verwendung das Lichtemissionstiming basierend auf dem Zuführtiming des Zielmaterials (63) von dem Zuführabschnitt (21) definiert ist.

**10.** Die Belichtungsausrüstung gemäß Anspruch 1, wobei in Verwendung das Lichtemissionstiming durch Ermitteln des gepulsten Lichts definiert ist.

**Revendications**

**1.** Équipement d'exposition utilisé avec une partie d'émission de lumière (11) qui génère de la lumière pulsée présentant une période d'émission de lumière (De), en produisant un plasma à partir d'un matériau cible (63) fourni par intermittence à partir d'une partie de fourniture (21), comprenant :

un étage de réticule (47) sur lequel un réticule (55) à irradier avec ladite lumière pulsée est agencé et mobile le long d'une direction de balayage au cours d'un temps d'exposition de balayage ;
un étage de substrat photosensible (49) sur lequel un substrat photosensible (59) à irradier avec la lumière pulsée est arrangé et mobile le long de la direction de balayage, à une période de commande d'entraînement (Ds), au cours du temps d'exposition de balayage, la lumière pulsée étant modélisée par ledit réticule (55) ; et une partie de commande (61) apte à obtenir des informations concernant une temporisation d'entraînement dudit étage de substrat photosensible (49) et une temporisation d'émission de lumière de ladite lumière pulsée, avant le début de l'exposition sur ledit substrat photosensible (59), et à commander un déplacement dudit étage de substrat photosensible (49) de sorte qu'une temporisation dudit étage de substrat photosensible (49) atteignant un point de début d'exposition ou un point de fin d'exposition et une temporisation de ladite lumière pulsée atteignant ledit substrat photosensible (59) coïncident l'une et l'autre sur la base des informations obtenues.

2. Équipement d'exposition selon la revendication 1, comprenant en outre :

une partie de détection (73) destinée à détecter la temporisation d'émission de lumière avant le début de l'exposition.

3. Équipement d'exposition selon la revendication 1, dans lequel :

en cours d'utilisation, ladite temporisation de ladite lumière pulsée atteignant ledit substrat photosensible (59) est définie sur la base d'une temporisation de fourniture dudit matériau cible (63) à partir de ladite partie de fourniture (21).

4. Équipement d'exposition selon la revendication 3, dans lequel :

en cours d'utilisation, la temporisation de fourniture dudit matériau cible (63) est définie en détectant un moment de fourniture dudit matériau cible (63) à partir de la partie de fourniture (21).

5. Équipement d'exposition selon la revendication 3, dans lequel :

en cours d'utilisation, la temporisation de fourniture dudit matériau cible est définie par un signal de commande de fourniture de la partie de fourniture (21).

6. Équipement d'exposition selon l'une quelconque des revendications 1 à 5, dans lequel :

en cours d'utilisation, la période de commande d'entraînement est une période fixe.

7. Équipement d'exposition selon la revendication 6, dans lequel :

en cours d'utilisation, ladite partie de commande (61) démarre l'exposition en synchronisant ladite période de commande avec une période de ladite lumière pulsée.

8. Équipement d'exposition selon la revendication 7, dans lequel :

en cours d'utilisation, ladite partie de commande (61) met en oeuvre ladite synchronisation en retardant un instant de début de déplacement dudit étage de substrat photosensible (49).

9. Équipement d'exposition selon la revendication 1, dans lequel :

en cours d'utilisation, la temporisation d'émission de lumière est définie sur la base de la temporisation de fourniture dudit matériau cible (63) à partir de la partie de fourniture (21).

10. Équipement d'exposition selon la revendication 1, dans lequel :

en cours d'utilisation, la temporisation d'émission de lumière est définie en détectant ladite lumière pulsée.

**Fig.1**

Laser apparatus

Laser target control apparatus

Control apparatus

Illumination optical system

Projection optical system

Reticle stage

Wafer stage

Stage control time chart     Light emission time chart

**Fig.2**

O (time origin point)

D s

T of

D e

T se a

T se b

Exposure starting point (before synchronization)

Exposure starting point (after synchronization)

Fig.3

Fig.4

Laser apparatus

Laser target control apparatus

Control apparatus

Illumination optical system

Projection optical system

Reticle stage

Wafer stage

**EP 1 811 545 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000215998 A
- US 2003037878 A1
- US 5883701 A
- JP 2004039927 A